# DEMANDE DE BREVET EUROPEEN

(11) **EP 2 461 362 A1**
(43) Date de publication de la demande: **06.06.2012**
(21) Numéro de dépôt: 10193873.6
(22) Date de dépôt: 06.12.2010
(51) Int. Cl.: H01L 25/04, H01L 27/142, H01L 31/048, H01L 31/042

(54) **Panneau solaire photovoltaïque à diodes en couches minces**

(71) Demandeur: Solsia, F-75006 Paris (FR)
(72) Inventeur: Turlot, Emmanuel, 38700, CORENC (FR); Meot, Jacques, 75006, PARIS (FR)
(74) Mandataire: de Beaumont, Michel

(57) **Abrégé**

L'invention concerne un panneau solaire comprenant une première plaque (21) comprenant sur une première face des bandes de premières diodes (21) mises en série par leurs grands côtés, et une seconde plaque (11) comprenant sur une première face des bandes de secondes diodes (13) mises en série par leurs grands côtés. Les premières faces des plaques sont accolées avec interposition d'une couche transparente (20) ; le panneau est éclairé du côté de la première plaque ; les premières diodes (23) sont adaptées à photoconvertir des rayonnements lumineux de longueur d'onde inférieure à une première valeur et à développer une première tension ; les secondes diodes sont adaptées à photoconvertir des rayonnements lumineux de longueur d'onde inférieure à une seconde valeur supérieure à la première valeur et à développer une seconde tension ; le rapport entre les largeurs des premières et deuxièmes bandes est égal au rapport entre les première et seconde tensions.

## Description

### Domaine de l'invention

La présente invention concerne un panneau solaire à diodes photovoltaïques en couches minces.

### Exposé de l'art antérieur

On connaît de nombreuses techniques de réalisation de panneaux solaires photovoltaïques constitués de diodes semiconductrices. On s'intéressera ici plus particulièrement aux panneaux solaires à couches minces dans lesquels les diodes sont constituées de silicium amorphe, micro-cristallin ou polymorphe hydrogéné, ou d'alliages amorphes, micro-cristallins ou polymorphes de silicium tels que le silicium-germanium ou le silicium-carbone amorphe hydrogéné, ou de tout autre matériau déposé en couche mince à basse température (inférieure à 300°C) comme le tellure de cadmium (CdTe), le di-séléniure de cuivre indium (CIS). Ceci permet d'obtenir des panneaux de grandes dimensions à des coûts relativement raisonnables.

On a étudié de nombreux montages de telles diodes et la théorie montre que, pour obtenir un rendement optimum, on a intérêt à disposer en série des diodes photovoltaïques strictement identiques. Par ailleurs, pour convertir toutes les longueurs d'ondes du rayonnement solaire du proche ultraviolet au proche infrarouge, il n'est pas souhaitable d'utiliser des diodes identiques dont la largeur de bande interdite est propre à absorber toutes les longueurs d'onde visées. En effet, quand on utilise des diodes à faible largeur de bande interdite, deux phénomènes concourent à réduire le rendement de conversion. D'une part, plus le matériau semiconducteur à une largeur de bande interdite réduite, plus il contient de défauts électroniques qui augmentent la probabilité de recombinaison des porteurs de charges créés par les photons absorbés. Le gain du à une absorption plus complète du spectre de la lumière solaire ne se traduit alors pas par un meilleur rendement de conversion. D'autre part, il se produit une génération de porteurs thermiques, qui est d'autant plus importante que la largeur de bande interdite est faible. La combinaison de ces deux effets limite les rendements de conversion à des valeurs nettement inférieures à 10 %. On a donc montré qu'il était souhaitable d'utiliser successivement des premières diodes absorbant les longueurs d'onde les plus faibles, par exemple inférieures à la longueur d'onde du jaune, qui sont traversées par la lumière qui atteint ensuite des deuxièmes diodes susceptibles d'absorber les longueurs d'onde allant jusqu'au proche infrarouge.

Il se pose toutefois un problème pour réaliser de tels empilements de diodes, plus particulièrement dans le cas où on souhaite connecter en série toutes les diodes d'un même type.

### Résumé

Ainsi, un objet de la présente invention est de prévoir un assemblage de deux types différents de diodes respectivement destinées à absorber les longueurs d'onde lumineuses les plus faibles et les longueurs d'onde lumineuses les plus élevées du rayonnement solaire, ce montage étant particulièrement efficace et simple à réaliser.

Pour atteindre cet objet, un mode de réalisation de la présente invention prévoit un panneau solaire comprenant une première plaque comprenant sur une première face des bandes de premières diodes mises en série par leurs grands côtés ; une seconde plaque comprenant sur une première face des bandes de secondes diodes mises en série par leurs grands côtés. Les premières faces des première et seconde plaques sont accolées avec interposition d'une couche transparente ; le panneau est adapté à être éclairé du côté de la première plaque ; les premières diodes sont adaptées à photoconvertir des rayonnements lumineux de longueur d'onde inférieure à une première valeur et à développer une première tension ; les secondes diodes sont adaptées à photoconvertir des rayonnements lumineux de longueur d'onde inférieure à une seconde valeur supérieure à la première valeur et à développer une seconde tension ; et le rapport entre les largeurs des premières bandes et des deuxièmes bandes est sensiblement égal au rapport entre les première et seconde tensions.

Selon un mode de réalisation de la présente invention, les bandes de diodes sont disposées entre des bandes conductrices supérieures et inférieures, chaque bande conductrice supérieure étant en contact avec une bande conductrice inférieure par l'une de ses extrémités.

Selon un mode de réalisation de la présente invention, la plaque supérieure est en verre.

Selon un mode de réalisation de la présente invention, les bandes conductrices des premières diodes et les bandes conductrices supérieures des secondes diodes sont en un matériau conducteur transparent.

Selon un mode de réalisation de la présente invention, les premières diodes sont des diodes PIN à base de silicium amorphe.

Selon un mode de réalisation de la présente invention, les secondes diodes sont des diodes NIP à base de silicium-germanium amorphe.

Selon un mode de réalisation de la présente invention, les bandes conductrices inférieures adjacentes à la deuxième plaque sont en un matériau conducteur réflecteur.

Selon un mode de réalisation de la présente invention, les secondes plaques sont constituées à partir de feuilles ou de rouleaux d'un métal revêtu d'un isolant.

Selon un mode de réalisation de la présente invention, la couche transparente est en un polymère transparent choisi avec addition d'une charge pour diffuser la lumière.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 représente un assemblage de diodes que la présente invention vise à réaliser ;
la figure 2 est une vue en coupe et en perspective partielle illustrant un exemple d'assemblage monocouche connu de diodes ; et
la figure 3 est une vue en coupe partielle illustrant un assemblage bicouche de diodes selon un mode de réalisation de la présente invention.

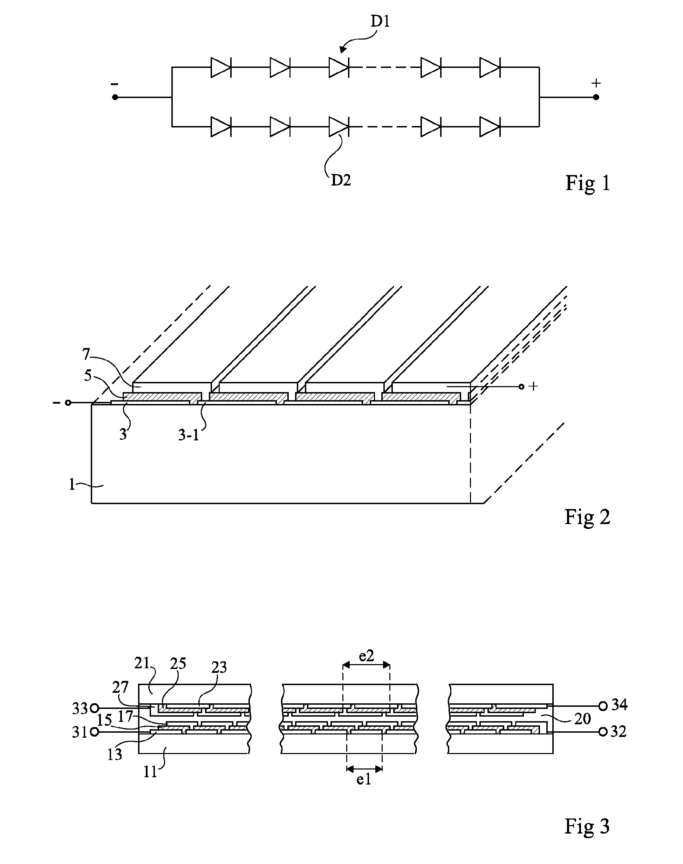

On cherche à réaliser de façon intégrée deux séries de diodes en parallèle comme cela est représenté en figure 1, à savoir une série de diodes D1 sensibles à de la lumière de longueur d'onde inférieure à une première valeur, par exemple environ 500 nm, et une seconde série de diodes D2 sensibles à de la lumière de longueur d'onde inférieure à une seconde valeur supérieure à la première, par exemple environ 1 µm.

En outre, pour limiter les pertes, on prévoit un premier nombre m de diodes D1 en série dont chacune fournit pour un éclairement solaire standard une tension V1 et un deuxième nombre n de deuxièmes diodes D2 en série fournissant une tension individuelle V2 tels que mV1 = nV2. Ainsi, les tensions produites dans des conditions d'éclairement standard par chacune des chaînes de diodes seront égales et la mise en parallèle fournira un rendement de conversion optimum. Par exemple, si les diodes D1 fournissent individuellement une tension V1 de 0,85 V et si les diodes D2 fournissent individuellement une tension V2 de 0,6 V, on choisira le rapport m/n égal à un multiple entier du rapport des tensions V2/V1 soit 0,6/0,85 = 12/17.

Pour la réalisation d'une chaîne de diodes, l'inventeur a sélectionné parmi les dispositifs existants, un panneau solaire du type décrit dans le brevet américain N° 4 315 096 (déposé le 25 juillet 1981 et cédé à Eastman Kodak). La figure 2 représente un exemple de structure telle que décrite dans ce brevet. Sur un substrat 1 est déposé une couche métallique divisée en bandes 3 par découpe laser. Sur ces bandes 3 et dans les intervalles entre bandes est déposée une couche semiconductrice dopée, pendant le dépôt ou ultérieurement, pour former, dans son épaisseur, une diode PIN. Cette couche semiconductrice est divisée par découpe laser en portions 5 recouvrant sensiblement les électrodes 3. La découpe est faite de sorte qu'une partie 3-1 de chaque bande conductrice 3 est découverte. Ensuite est déposée une deuxième couche conductrice également divisée en bandes 7, de façon que chaque bande conductrice 7 recouvre une portion de la bande semiconductrice 5 et vient en contact avec la partie 3-1 de l'électrode inférieure. Ainsi, entre des bornes - et +, on trouve successivement une bande conductrice 3, une bande semiconductrice 5 constituant une diode, une bande conductrice 7, une bande conductrice 3, une diode 5, une bande conductrice 7 et ainsi de suite, de façon que les diodes en forme de bandes se trouvent connectées en série par leurs grands côtés.

Comme le représente la figure 3, le panneau solaire décrit ici comprend deux structures selon la figure 2 collées l'une contre l'autre par une couche de collage 20, les substrats constituant les faces externes de la structure. Ainsi, le panneau solaire comprend une plaque substrat inférieure 11 portant des bandes d'électrodes 13, des bandes de diodes semiconductrices 15 et des bandes d'électrodes 17, assemblées comme les électrodes 3, les diodes 5 et les électrodes 7 de la figure 2. Une plaque substrat supérieure 21 porte également successivement des bandes d'électrodes 23, des bandes de diodes semiconductrices 25 et des bandes d'électrodes 27 également assemblées comme des éléments correspondant 3, 5 et 7 de la figure 2. Les électrodes de la plaque inférieure sont connectées en série entre des bornes 31, 32 et les électrodes de la plaque supérieure sont connectées en série entre des électrodes 33, 34. Si ce sont les diodes D1, à savoir les diodes sensibles seulement au rayonnement de faible longueur d'onde qui sont placées sur la plaque supérieure 21, on prévoira que cette plaque 21 est une plaque transparente, par exemple en verre. De même, les électrodes 23, 27 de la plaque supérieure et les électrodes supérieures 17 de la plaque inférieure seront des électrodes transparentes pour que les rayonnements de plus forte longueur d'onde, non absorbés par les diodes supérieures, puissent atteindre les diodes inférieures 15. Par contre, les électrodes inférieures 13 seront de préférence en un matériau fortement réflecteur, de façon à renvoyer la lumière non absorbée à nouveau vers les diodes. De même, la couche de collage 30 sera une couche transparente, de préférence diffusante pour augmenter la longueur du parcours de la lumière dans les diodes inférieures en favorisant le piégeage optique de cette lumière qui survient à de forts angles de diffraction.

Selon un aspect fondamental du panneau solaire décrit ici, les largeurs des bandes de diodes de la plaque supérieure et de la plaque inférieure sont différentes de sorte qu'il y ait sur chacune des plaques des nombres de diodes respectifs m et n dans le rapport inverse des tensions V1 et V2 fournies par les diodes individuelles de la plaque supérieure et de la plaque inférieure. Par exemple, si les diodes de la plaque supérieure fournissent individuellement une tension de l'ordre de 0,85 V, et les diodes de la plaque inférieure une tension de l'ordre de 0,6 V, le rapport des largeurs sera dans le rapport des tensions, c'est-à-dire dans le rapport 17/12 de façon que k.17 diodes de la plaque inférieure correspondent à k.12 diodes de la plaque supérieure, k étant un entier. Ainsi, les deux chaînes de diodes fournissent aux bornes extrêmes 31, 32 et 33, 34 une même tension.

Selon un avantage de la présente invention, on notera que le matériau de collage 30 qui est souvent un matériau qui se dégrade en présence de rayons ultraviolets est protégé de tout rayonnement ultraviolet par les éléments de la plaque supérieure qui reçoivent le rayonnement solaire incident.

Selon un autre avantage de la présente invention, le matériau de collage 30 peut être remplacé par un matériau diffusant non adhésif et le maintien des deux plaques l'une contre l'autre peut alors être réalisé par le scellement sous vide de ces deux plaques. On sépare alors les fonctions de diffusion et d'encapsulation, ce qui permet d'employer des matériaux diffusants plus efficaces et d'exploiter pour l'application photovoltaïque visée des solutions d'encapsulation développées et éprouvées par l'industrie des écrans plats.

Selon un autre avantage de la présente invention, la séparation de la réalisation des diodes supérieures et inférieures sur deux substrats différent permet l'emploi de matériaux semiconducteurs qu'il ne serait pas possibles de déposer successivement avec une qualité optimale sur un même substrat. Cette séparation offre de surcroît la possibilité de rejet en production de l'un ou de l'autre panneau s'il est détecté défectueux avant l'assemblage et donc de réduire les coûts de production.

Un exemple de panneau solaire selon la présente invention a été décrit de façon générale ci-dessus. On indiquera ci-après, uniquement à titre d'exemple, des caractéristiques qui peuvent être utilisées pour chacun des éléments constitutifs de ce panneau.

Le substrat inférieur pourra être en tout matériau choisi, par exemple en verre ou en métal revêtu d'une couche isolante (pour ne pas court-circuiter les électrodes inférieures 13). Il pourra par exemple s'agir d'une feuille ou rouleau souple d'acier inoxydable ou autre revêtu d'oxyde de silicium.

Les électrodes inférieures 13 pourront être en aluminium ou en argent, déposées par exemple en une couche mince d'une épaisseur de 100 nm. On pourra également combiner un empilement d'une couche métallique et d'une couche transparente et conductrice (oxyde d'indium et d'étain, oxyde de zinc, oxyde d'étain,...) d'une épaisseur de l'ordre du quart de la longueur d'onde moyenne que l'on souhaite réfléchir, pour augmenter par effet interférentiel le taux de réflexion sur l'électrode 13 ainsi réalisée.

Les diodes inférieures 15 seront de préférence des diodes NIP en silicium-germanium amorphe d'une épaisseur de l'ordre de 200 nm ou en silicium microcristallin d'une épaisseur de 2000 nm.

Les diodes supérieures 23 sont de préférence des diodes PIN en silicium amorphe ou polymorphe d'une épaisseur de l'ordre de 200 nm.

Les diverses électrodes transparentes 17, 23 et 27 seront généralement en un oxyde conducteur transparent tel que de l'ITO (oxyde d'indium et d'étain), du Zno, du SnO₂ et auront couramment une épaisseur de l'ordre de 1 à 3 micromètres.

La couche de collage est en tout polymère approprié, par exemple de l'EVA (acétate d'éthylène-vinyle) qui peut comme on l'a indiqué précédemment être utilisé sans inconvénient puisqu'il est protégé des rayons ultraviolets et ne se dégrade pas. Ce matériau n'étant pas diffusant mais fluide avant polymérisation, on pourra ajouter avant assemblage des particules appropriées pour obtenir une couche diffusante.

Le substrat supérieur 21 sera par exemple une plaque de verre.

Un panneau selon la présente invention peut avoir des dimensions de 1 m², les bandes de diodes ayant par exemple une longueur de 1 m et une largeur de l'ordre de 10 mm (en respectant le rapport de largeur indiqué ci-dessus).

La surface supérieure des diodes, des côtés opposés aux substrats, est généralement rugueuse, et donc l'interface entre ces couches de diodes et l'électrode voisine est diffusante, ce qui améliore encore le rendement de conversion du système, les rayons lumineux arrivant obliquement dans les diodes et parcourant un plus grand trajet dans le semiconducteur ce qui augmente la probabilité de photoconversion. Cette diffusion a aussi pour avantage de réduire la réflexion spéculaire sur la face avant du panneau solaire et donc de lui donner un aspect mat qui est très recherché dans le bâtiment (toiture, facades...).

Avec une telle structure, on peut obtenir un rendement de photoconversion de l'ordre de 13 %, ce qui est nettement supérieur à ce qui est fourni par l'ensemble des panneaux actuellement connus employant ces matériaux semiconducteurs en couche mince.

Divers modes de réalisation avec diverses variantes ont été décrits ci-dessus. On notera que l'homme de l'art pourra combiner divers éléments de ces divers modes de réalisation et variantes sans faire preuve d'activité inventive. Notamment au lieu de mettre en série toutes les diodes d'un panneau, on pourra réaliser divers assemblages série/parallèle.

## Revendications

1. Panneau solaire comprenant :
une première plaque (21) comprenant sur une première face des bandes de premières diodes (21) mises en série par leurs grands côtés ;
une seconde plaque (11) comprenant sur une première face des bandes de secondes diodes (13) mises en série par leurs grands côtés ;
dans lequel :
les premières faces des première et seconde plaques sont accolées avec interposition d'une couche transparente (20) ;
le panneau est adapté à être éclairé du côté de la première plaque ;
les premières diodes (23) sont adaptées à photoconvertir des rayonnements lumineux de longueur d'onde inférieure à une première valeur et à développer une première tension (V1) ;
les secondes diodes sont adaptées à photoconvertir des rayonnements lumineux de longueur d'onde inférieure à une seconde valeur supérieure à la première valeur et à développer une seconde tension (V2) ;
le rapport entre les largeurs des premières bandes et des deuxièmes bandes est sensiblement égal au rapport entre les première et seconde tensions.

2. Panneau solaire selon la revendication 1, dans lequel les bandes de diodes sont disposées entre des bandes conductrices supérieures et inférieures (23, 27 ; 13, 17), chaque bande conductrice supérieure étant en contact avec une bande conductrice inférieure par l'une de ses extrémités.

3. Panneau solaire selon la revendication 1 ou 2 dans lequel la plaque supérieure est en verre.

4. Panneau solaire selon la revendication 2 ou 3, dans lequel les bandes conductrices (23, 27) des premières diodes et les bandes conductrices supérieures (17) des secondes diodes sont en un matériau conducteur transparent.

5. Panneau solaire selon la revendication 1, dans lequel les premières diodes sont des diodes PIN à base de silicium amorphe.

6. Panneau solaire selon la revendication 1, dans lequel les secondes diodes sont des diodes NIP à base de silicium-germanium amorphe.

7. Panneau solaire selon l'une quelconque des revendications 1 à 6, dans lequel les bandes conductrices inférieures (13) adjacentes à la deuxième plaque sont en un matériau conducteur réflecteur.

8. Panneau solaire selon l'une quelconque des revendications 1 à 7, dans lequel les secondes plaques sont constituées à partir de feuilles ou de rouleaux d'un métal revêtu d'un isolant.

9. Panneau solaire selon l'une quelconque des revendications 1 à 8, dans lequel la couche transparente (20) est en un polymère transparent choisi avec addition d'une charge pour diffuser la lumière.
